Europäisches Patentamt

(19) European Patent Office

Office européen des brevets

(11) Numéro de publication: **0 090 696**
**B1**

(12) **FASCICULE DE BREVET EUROPEEN**

(45) Date de publication du fascicule du brevet: **20.05.87**

(51) Int. Cl.⁴: **H 05 K 3/22, H 05 K 1/00**

(21) Numéro de dépôt: **83400507.6**

(22) Date de dépôt: **11.03.83**

(54) **Procédé de fabrication de circuits imprimés avec support métallique rigide conducteur individuel.**

(30) Priorité: **23.03.82 FR 8204916**

(43) Date de publication de la demande:
**05.10.83 Bulletin 83/40**

(45) Mention de la délivrance du brevet:
**20.05.87 Bulletin 87/21**

(84) Etats contractants désignés:
**BE CH DE IT LI NL SE**

(56) Documents cités:
**FR-A-1 403 061**
**FR-A-2 137 001**
**US-A-3 955 068**

**ELEKTROTECHNIEK/ELEKTRONICA, vol. 29, no. 20, 2 octobre 1974, page 665, NL. "Flexibele, gedrukte filmbedraïding"**

*Le dossier contient des informations techniques présentées postérieurement au dépôt de la demande et ne figurant pas dans le présent fascicule.*

(73) Titulaire: **THOMSON-CSF**
**173, Boulevard Haussmann**
**F-75379 Paris Cedex 08 (FR)**

(72) Inventeur: **Iliou, Louis**
**THOMSON-CSF SCPI 173, Bld. Haussmann**
**F-75379 Paris Cedex 08 (FR)**
Inventeur: **Gotkovsky, Bruno**
**THOMSON-CSF SCPI 173, Bld. Haussmann**
**F-75379 Paris Cedex 08 (FR)**

(74) Mandataire: **Chaverneff, Vladimir et al**
**THOMSON-CSF SCPI 19, avenue de Messine**
**F-75008 Paris (FR)**

Courier Press, Leamington Spa, England.

## Description

La présente invention se rapporte à un procédé de fabrication de circuits imprimés avec support métallique rigide conducteur individuel.

Lorsque l'on veut obtenir, en particulier dans un dispositif fonctionnant en hyperfréquences, un circuit imprimé dont au moins une partie des conducteurs imprimés présentent une impédance déterminée de façon précise par rapport à un potentiel déterminé, en particulier un plan de masse qui est généralement le châssis ou le boîtier de ce dispositif, on réalise ce circuit imprimé sur un substrat céramique qui est collé sur ce châssis ou boîtier. Un tel procédé permet d'obtenir de bons résultats, mais le circuit imprimé n'est pas démontable et ne peut être enlevé du châssis ou boîtier sans dommage, ce qui peut constituer une gêne considérable dans certains cas, par exemple lors de la mise au point de matériels. Par ailleurs, on a proposé de coller des plaques de circuits imprimés gravées et usinées sur des supports rigides, la colle étant chargée de particules conductrices pour l'utilisation en UHF, mais les remontées de colle provoquées lors de l'étape de collage sous pression obstruaient les perçages des plaques et ne pouvaient être éliminées complètement, ce qui provoquait des défauts de fonctionnement inadmissibles en UHF.

On connaît d'après FR—A—1 403 061, un procédé de fabrication de masses pour plaquettes de circuit imprimé consistant soit à fixer soit à imprimer un plan métallique sur une plaque isolante. La fixation par collage risque de provoquer des remontées de colle, tandis que l'impression, qui ne peut se faire que sur une plaque rigide, risque de faire pénétrer l'encre d'impression dans les trous ou alvéoles pratiqués dans la plaque isolante, ces deux phénomènes risquant de faire varier les caractéristiques électriques des éléments fixés ou imprimés sur la plaque par rapport au plan de masse, ce qui est absolument interdit en UHF.

La présente invention a pour objet un procédé permettant de réaliser des circuits imprimés dont au moins une partie des conducteurs imprimés présentent des caractéristiques électriques déterminées par rapport au châssis ou boîtier du dispositif dont ils font partie, ces circuits imprimés étant facilement amovibles.

La présente invention a également pour objet un procédé du type précité permettant de rigidifier un support isolant souple de circuit imprimé, ce circuit pouvant alors être, le cas échéant, facilement fixé sur un châssis ou boîtier, et facilement retiré si nécessaire.

Le procédé conforme à la présente invention consiste à graver de façon classique le circuit imprimé sur une face d'une plaque de substrat isolant, avantageusement souple, métallisé ou revêtu de feuilles métalliques sur les deux faces, au moins le revêtement métallique de la face destinée à être gravée étant en métal susceptible d'être gravé, à découper une plaque métallique rigide de support ayant des dimensions au moins égales à celles de ladite plaque de substrat, à coller, à l'aide d'un film thermofusible électriquement conducteur, la plaque de substrat sur la plaque rigide de support, puis à usiner l'ensemble des deux plaques collées.

Le procédé de l'invention sera mieux compris à l'aide de la description détaillée d'un exemple non limitatif de mise en oeuvre décrit ci-dessous.

Le procédé décrit ci-dessous en détail se rapporte à la fabrication d'un circuit imprimé destiné à fonctionner en UHF et dans lequel certains conducteurs imprimés doivent former des circuits capacitifs par rapport à un plan de masse sur lequel doit être fixé ce circuit imprimé. A cet effet, on choisit pour le circuit imprimé un substrat présentant une constante diélectrique appropriée et découpé aux dimensions désirées. Généralement, lorsque la capacité présentée par lesdits circuits capacitifs doit être relativement élevée, on choisit un substrat ayant une constante diélectrique la plus élevée possible, à condition qu'elle soit pratiquement homogène et constante, afin que les conducteurs du circuit imprimé formant circuits capacitifs n'aient pas des dimensions trop élevées.

Dans le présent exemple de mise en oeuvre, ce substrat est un substrat souple, de préférence du "Téflon" (marque déposée) chargé céramique ayant une constante diélectrique d'environ 10 à 12 et présentant de plus l'avantage d'être facile à découper et à usiner. Un tel produit est par exemple commercialisé sous les appellations "Epsilame 10" ou "Duroïd 6010" ou "Diclad 810". Ces produits sont plaqués cuivre sur les deux faces. Lors de la gravure chimique du circuit imprimé, ou protège de façon appropriée l'une des deux faces, et l'on effectue la gravure sur l'autre face. De préférence, on dépose une couche de métal très bon conducteur électrique, tel que l'or, sur les conducteurs du circuit imprimé pour éviter les inconvénients de l'effet de peau.

D'autre part, on prépare la plaque métallique rigide devant supporter la plaque souple de circuit imprimé. Dans le présent exemple, cette plaque rigide est en aluminium, et ses dimensions sont avantageusement légèrement supérieures à celles du circuit imprimé: ainsi on n'a pas besoin d'effectuer un positionnement très précis de la plaque souple par rapport à la plaque rigide, et les débordements de colle se produisant lors de l'étape ultérieure de mise sous pression ne risquent pas de tomber sur les équipements environnants. Si nécessaire, on peut appliquer un traitement anticorrosion à la plaque rigide. Dans le cas où elle est en aluminium, on peut la chromater chimiquement.

Ensuite, on ponce, on dégraisse et on sèche les faces à coller de la plaque rigide et de la plaque souple, et on dégaze ces plaques dans une étuve portée par exemple à 80°C environ pendant une heure.

Les deux plaques sont alors prêtes à collées ensemble. De préférence, on utilise en tant que matériau de collage un film adhésif époxyde électriquement conducteur, tel que le film "Ablefilm ECF 550" (marque déposée). Ce film est découpé aux dimensions de la plaque souple, en évitant toute contamination pendant sa manipulation. Dès que l'on sort de l'étuve la plaque rigide et la plaque souple à circuit imprimé, on positionne rapidement le film adhésif découpé entre les faces à coller de ces deux plaques, et on applique aussitôt une pression à l'ensemble des deux plaques et du film adhésif disposé entre elles.

Cette pression peut par exemple être appliquée à l'aide de rouleaux presseurs entre lesquels on fait passer cet ensemble. La pression peut être de l'ordre de quelques kfg/cm². Le film adhésif devenu poisseux grâce à la chaleur qui lui est communiquée par les deux plaques (après leur sortie de l'étuve de dégazage, les deux plaques sont manipulées le plus rapidement possible pour rester suffisamment chaudes au moment où la pression leur est appliquée) adhère aux deux plaques. Ladite pression est choisie suffisamment élevée pour favoriser un bon collage, mais pas trop élevée pour éviter un débordement excessif du film adhésif.

On termine le collage en plaçant ledit ensemble dans une étuve, pour durcissement, en le soumettant à une pression constante, de l'ordre de 1 kgf/cm². Dans le cas où l'on utilise ledit "Ablefilm 550", cette étape de durcissement est, de préférence, effectuée à 120°C pendant quatre heures environ.

Enfin, on usine le circuit imprimé et son support pour amener la plaque rigide à la bonne dimension et pour réaliser en particulier des trous pour le passage de vis de fixation des plaques sur un châssis ou dans un boîtier, et, le cas échéant, des trous pour le logement des extrémités des fils de raccordement des composants à souder sur le circuit imprimé, ces composants étant bien entendu disposés côté "Cuivre" du circuit imprimé. Si ces films de raccordement ne doivent pas être reliés à la masse, ou tout au moins à la plaque rigide de support, on prend évidemment des mesures pour isoler les extrémités de ces fils par rapport à la plaque rigide, par exemple en pratiquant des trous borgnes dans le substrat du circuit imprimé.

Grâce au procédé de l'invention, on obtient des circuits imprimés facilement amovibles dont le support rigide peut être mis à la masse où à un potentiel déterminé. Par un choix approprié du métal de la plaque de support rigide, on peut pratiquement éliminer les effets des contraintes thermiques exercées sur ce support par le châssis ou boîtier sur lequel il est fixé. Ces circuits imprimés étant utilisés en UHF, leur substrat peut avoir une constante diélectrique élevée, ce qui peut permettre de réduire les dimensions de ces circuits.

## Revendications

1. Procédé de fabrication de circuits imprimés UHF dont au moins une partie des conducteurs imprimés présentent des caractéristiques électriques déterminées par rapport au châssis ou boîtier du dispositif dont ils font partie, caractérisé par le fait que l'on grave de façon classique le circuit imprimé sur une face d'une plaque de substrat isolant métallisé ou revêtu de feuilles métalliques sur les deux faces, au moins le revêtement métallique de la face destinée à être gravée étant en métal susceptible d'être gravé, que l'on découpe un plaque métallique rigide de support ayant des dimensions au moins égales à celles de ladite plaque du substrat, que l'on colle la plaque de substrat sur la plaque rigide de support à l'aide d'un film thermofusible électriquement conducteur préalablement découpé aux dimensions du substrat, et que l'on usine l'ensemble des deux plaques collées.

2. Procédé selon la revendication 1, caractérisé par le fait que le substrat isolant est un substrat en matériau souple, avantageusement en Teflon, et qu'il est revêtu de feuilles de cuivre sur les deux faces.

3. Procédé selon la revendication 2, caractérisé par le fait que le substrat est du Teflon chargé céramique.

4. Procédé selon l'une des revendications 1 à 3, caractérisé par le fait que le film adhésif est un film époxyde électriquement conducteur.

5. Procédé selon la revendication 4, caractérisé par le fait que pour coller les deux plaques, on les chauffe à une température d'environ 80°C, avantageusement dans une étuve de dégazage, on positionne le film adhésif entre ces deux plaques, on applique une pression à l'ensemble, et on fait durcir sous pression le film adhésif en chauffant l'ensemble à 120°C pendant quatre heures environ.

## Patentansprüche

1. Verfahren zur Herstellung von gedruckten UHF-Schaltungen, worin wenigstens ein Teil der gedruckten Leiter bestimmte elektrische Eigenschaften gegenüber dem Chassis oder Gehäuse der Vorrichtung aufweist, wovon sie Bestandteil sind, dadurch gekennzeichnet, daß in herkömmlicher Weise die integrierte Schaltung auf einer Fläche einer isolierenden, beidseitig metallisierten oder mit Metallfolien bedeckten Substratplatte eingraviert wird, wobei wenigstens die metallische Beschichtung der zu gravierenden Fläche aus einem gravierbaren Material besteht, daß eine starre metallische Trägerplatte ausgeschnitten wird, die Abmessungen aufweist, welche wenigstens gleich denen der genannten Substratplatte sind, daß die Substratplatte auf die starre Trägerplatte aufgeklebt wird mittels einer elektrisch leitfähigen, wärmeschmelzbaren Folie, die zuvor auf die Abmessungen des Substrats geschnitten wurde, und daß die aus den beiden verklebten Platten gebildete Einheit bearbeitet wird.

2. Verfahren nach Anspruch 1, dadurch gekennnzeichnet, daß das Isoliersubstrat ein Substrat aus flexiblem Material ist, vorteilhafterweise aus Teflon, und daß es beidseitig mit Kupferfolien bedeckt wird.

3. Verfahren nach Anspruch 2, dadurch gekennzeichnet, daß das Substrat aus keramisch befrachtetem Teflon besteht.

4. Verfahren nach einem der Ansprüche 1 bis 3, dadurch gekennzeichnet, daß die Haftfolie ein elektrisch leitfähiger Epoxydfilm ist.

5. Verfahren nach Anspruch 4, dadurch gekennzeichnet, daß die beiden Platten zum Verkleben auf eine Temperatur von etwa 80°C erwärmt werden, vorteilhafterweise in einem Entgasungskessel, daß die Haftfolie zwischen diesen beiden Platten angeordnet wird, daß ein Druck auf die Einheit ausgeübt wird und daß die Haftfolie durch Erwärmen der Einheit auf 120°C während etwa vier Stunden ausgehärtet wird.

**Claims**

1. Method of producing printed UHF circuits at least a portion of the printed conductors of which have electric characteristics determined with respect to the chassis or housing of the device they belong to, characterized by the fact that the printed circuit is engraved in conventional manner on one face of an insulating substrate plate which is metallized or covered with metallic foils on both faces, at least the metallic coating of the face intended to be engraved being of a metal susceptible to be engraved, that a rigid metallic carrier plate is cut with dimensions at least equal to those of said substrate plate, that the substrate plate is bonded on the rigid carrier plate by means of an electrically conductive thermo-fusible film which is previously cut to the dimensions of the substrate, and that the unit of the two bonded plates is worked.

2. Method according to claim 1, characterized by the fact that the insulating substrate is a substrate of flexible material, advantageously of Teflon, and in that it is coated with copper foils on both faces.

3. Method according to claim 2, characterized by the fact that the substrate is of ceramic-loaded Teflon.

4. Method according to any of claims 1 to 3, characterized by the fact that the adhesive film is an electrically conductive epoxy film.

5. Method according to claim 4, characterized by the fact that the two plates, in order to be bonded, are heated to a temperature of substantially 80°C, advantageously in a gas venting vessel, the adhesive film is positioned between the two plates, a pressure is applied to the unit and the adhesive film is cured under pressure by heating the unit to 120°C during about four hours.